(19) Europäisches Patentamt / European Patent Office / Office européen des brevets

(11) **EP 3 855 484 B1**

(12) **EUROPEAN PATENT SPECIFICATION**

(45) Date of publication and mention
of the grant of the patent:
**08.03.2023 Bulletin 2023/10**

(21) Application number: **18942258.7**

(22) Date of filing: **06.12.2018**

(51) International Patent Classification (IPC):
*H01L 23/373* (2006.01)    *H01L 23/15* (2006.01)
*C04B 37/02* (2006.01)    *H01L 23/36* (2006.01)
*H05K 1/02* (2006.01)    *H05K 1/03* (2006.01)
*C04B 35/119* (2006.01)

(52) Cooperative Patent Classification (CPC):
**H01L 23/3735; C04B 35/119; C04B 37/021;**
**C04B 37/025; H01L 23/15; H05K 1/0306;**
C04B 2235/3201; C04B 2235/3206;
C04B 2235/3208; C04B 2235/3217;
C04B 2235/3225; C04B 2235/3244;
C04B 2235/3418; C04B 2235/6025;
C04B 2235/6567;                    (Cont.)

(86) International application number:
**PCT/JP2018/044943**

(87) International publication number:
**WO 2020/115869 (11.06.2020 Gazette 2020/24)**

(54) **SUBSTRATE FOR SEMICONDUCTOR DEVICE**

SUBSTRAT FÜR HALBLEITERBAUELEMENT

SUBSTRAT POUR DISPOSITIF À SEMI-CONDUCTEUR

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**28.07.2021 Bulletin 2021/30**

(73) Proprietors:
• **NGK Insulators, Ltd.**
  **Nagoya-shi, Aichi 467-8530 (JP)**
• **NGK Electronics Devices, Inc.**
  **Mine-shi, Yamaguchi 759-2212 (JP)**

(72) Inventor: **UMEDA, Yuji**
  **Mine-shi, Yamaguchi 759-2212 (JP)**

(74) Representative: **Müller-Boré & Partner**
  **Patentanwälte PartG mbB**
  **Friedenheimer Brücke 21**
  **80639 München (DE)**

(56) References cited:
**EP-A1- 3 210 951      EP-A1- 3 210 956**
**JP-A- H08 195 450      JP-A- 2015 138 830**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**(Cont. next page)**

(52) Cooperative Patent Classification (CPC): (Cont.)
C04B 2235/6583; C04B 2235/6585; C04B 2235/95;
C04B 2235/9607; C04B 2237/402; C04B 2237/407;
C04B 2237/54; C04B 2237/582; C04B 2237/704;
C04B 2237/706; H01L 23/36

**Description**

TECHNICAL FIELD

The present invention relates to a substrate for a semiconductor device.

BACKGROUND ART

As a substrate for a semiconductor device used for a power transistor module or the like, a DBOC substrate (Direct Bonding of Copper Substrate) including a copper plate on the surface of a ceramic sintered body or a DBOA substrate (Direct Bonding of Aluminum Substrate) including an aluminum plate on the surface of a ceramic sintered body is known.
PATENT LITERATURE 1 discloses a substrate for a semiconductor device including a ceramic sintered body containing alumina, partially stabilized zirconia, and magnesia. In the ceramic sintered body described in PATENT LITERATURE 1, the content of partially stabilized zirconia is 1 to 30 wt%, and the content of magnesia is 0.05 to 0.50 wt%. The molar fraction of yttria in partially stabilized zirconia is 0.015 to 0.035, and 80 to 100% of the zirconia crystals contained in the ceramic sintered body are tetragonal phases. The ceramic sintered body described in PATENT LITERATURE 1 is supposed to be capable of preventing cracks from occurring at the bonding interface between the ceramic sintered body and the circuit plate or the aluminum plate and improving the thermal conductivity.
PATENT LITERATURE 2 discloses a substrate for a semiconductor device including a ceramic sintered body containing alumina, zirconia, and yttria. In the ceramic sintered body described in PATENT LITERATURE 2, the content of zirconia is 2 to 15 wt%, and the average particle size of alumina is 2 to 8 $\mu$m. The ceramic sintered body described in PATENT LITERATURE 2 is supposed to be capable of improving the thermal conductivity.

Citation List

Patent Literature

[Patent Literature 1] JP 4717960B
[Patent Literature 2] JP 2015-534280A

SUMMARY

Technical Problem

However, in PATENT LITERATURE 1, although the thermal conductivity of the ceramic sintered body itself is examined, the thermal resistance of the semiconductor device substrate as a whole including the circuit plate (circuit plate or aluminum plate) has not been examined.
Similarly, in PATENT LITERATURE 2, the thermal resistance of the semiconductor device substrate as a whole is not examined, and cracks at the bonding interface are not examined either.
Therefore, as a result of diligent studies by the present inventor, a new finding that the combination of the composition of the ceramic sintered body and the thickness of each constituent member affects the thermal resistance of the substrate for semiconductor device and the cracks at the bonding interface has been obtained.
An object of the present invention is to provide a substrate for a semiconductor device capable of achieving both to reduce thermal resistance and prevent cracks.

Solution to Problem

The substrate for a semiconductor device according to the present invention includes a ceramic sintered body, a first circuit plate, and a second circuit plate. The ceramic sintered body is formed in a plate shape and has a first main surface and a second main surface. The first circuit plate is arranged on the first main surface and is constituted of copper or aluminum. The second circuit plate is arranged on the second main surface and is constituted of copper or aluminum. The ceramic sintered body contains Al, Zr, Y and Mg. In the ceramic sintered body, when the Mg content in terms of MgO is S1 mass% and the Zr content in terms of $ZrO_2$ is S2 mass%, the following formula (1) is established. When the thickness of the first circuit plate is T1 mm, the thickness of the second circuit plate is T2 mm, and the thickness of the ceramic sintered body is T3 mm, the following formulas (2), (3), and (4) are established.

$$-0.004 \times S2 + 0.171 < S1 < -0.032 \times S2 + 1.427 \cdots (1)$$

$$1.7 < (T1 + T2) / T3 < 3.5 \cdots (2)$$

$$T1 \geq T2 \cdots (3)$$

$$T3 \geq 0.25 \cdots (4)$$

Advantageous Effects of Invention

According to the present invention, it is possible to provide a substrate for a semiconductor device capable of achieving both to reduce thermal resistance and prevent cracks.

BRIEF DESCRIPTION OF DRAWINGS

FIG. 1 is a perspective view showing a configuration of a semiconductor device according to an embodiment.
FIG. 2 is a cross-sectional view of A-A in FIG. 1.

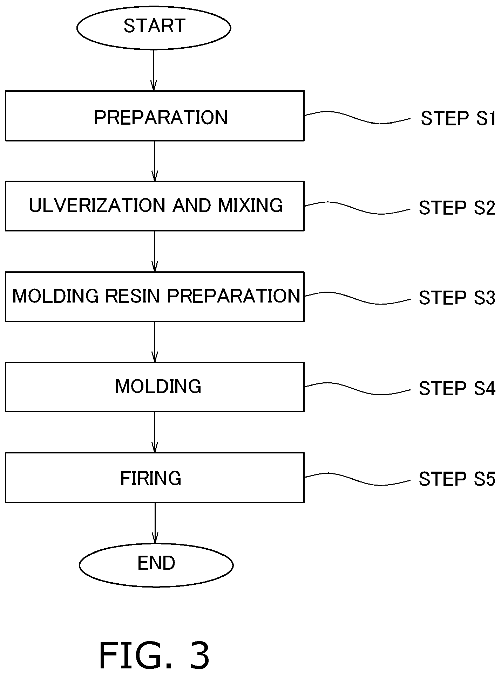

FIG. 3 is a flowchart for explaining a method of manufacturing a substrate for a semiconductor device according to an embodiment.

DESCRIPTION OF EMBODIMENTS

Hereinafter, the configuration of the semiconductor device according to the present invention will be described with reference to the drawings.

(Structure of semiconductor device 1)

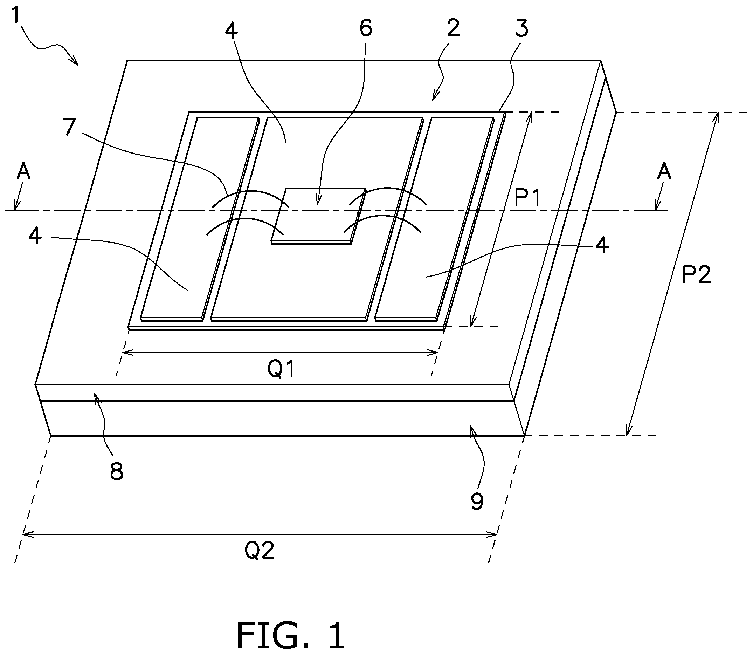

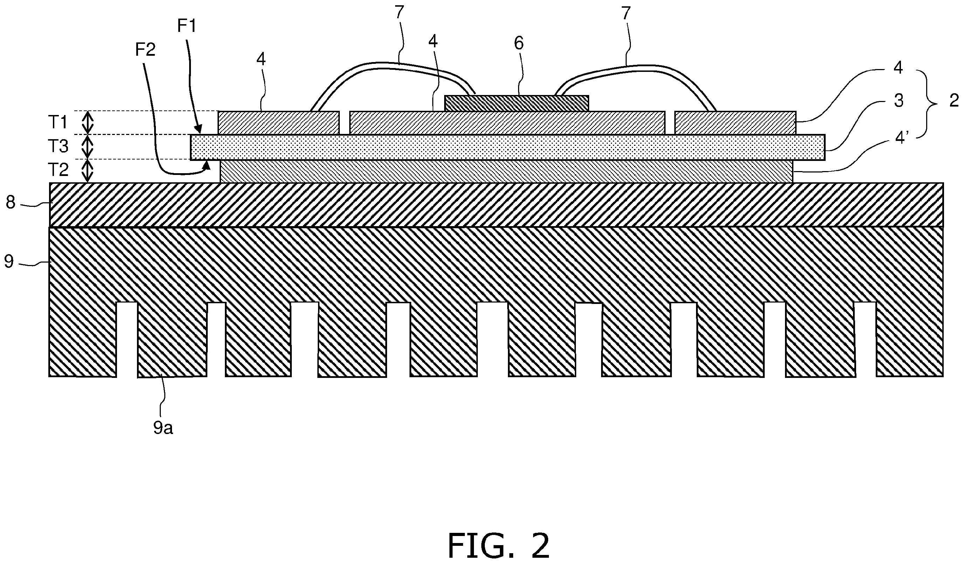

FIG. 1 is a perspective view of a semiconductor device 1 according to the embodiment. FIG. 2 is a cross-sectional view of A-A of FIG.

The semiconductor device 1 is used as power module in various electronic devices such as an automobile, an air conditioner, an industrial robot, a commercial elevator, a household microwave oven, an IH electric rice cooker, power generation (wind power generation, solar power generation, fuel cell, or the like), electric railway, UPS (uninterruptible power supply) or the like.

The semiconductor device 1 includes a semiconductor device substrate 2, a semiconductor chip 6, a bonding wire 7, a heat sink 8, and a heat radiating portion 9.

The semiconductor device substrate 2 is a so-called DBOC substrate (Direct Bonding of Copper Substrate) or a DBOA substrate (Direct Bonding of Aluminum Substrate).

The size and plane shape of the semiconductor device substrate 2 are not particularly limited but can be, for example, a square or rectangle having a vertical length P1 of 25 to 40 mm and a horizontal length Q1 of 35 to 50 mm. The thickness of each component constituting the semiconductor device substrate 2 will be described later.

The semiconductor device substrate 2 includes a ceramic sintered body 3, a first circuit plate 4, and a second circuit plate 4'.

The ceramic sintered body 3 is an insulator for the semiconductor device substrate 2. The ceramic sintered body 3 is formed in a flat plate shape. The ceramic sintered body 3 includes a first main surface F1 and a second main surface F2 on the opposite side of the first main surface. The constituent elements of the ceramic sintered body 3 will be described later.

The first circuit plate 4 is arranged on the first main surface F1 of the ceramic sintered body 3. The first circuit plate 4 is constituted of copper or aluminum. The first circuit plate 4 is formed in a flat plate shape. The first circuit plate 4 is directly bonded to the first main surface F1 of the ceramic sintered body 3. The first circuit plate 4 according to the present embodiment is composed of three plate members, whereby a transmission circuit is formed. However, the plane shape of the first circuit plate 4 is not particularly limited, and a desired transmission circuit may be formed by a plurality of plate members.

The coverage of the first main surface F1 by the first circuit plate 4 is not particularly limited but can be, for example, 85% or more and 95% or less. The coverage of the first main surface F1 by the first circuit plate 4 is obtained by dividing the total area of the first circuit plate 4 by the total area of the first main surface F1 in the plan view of the first main surface F1.

The second circuit plate 4' is arranged on the second main surface F2 of the ceramic sintered body 3. The second circuit plate 4' is constituted of copper or aluminum. The second circuit plate 4' is formed in a flat plate shape. The second circuit plate 4' is directly bonded to the second main surface F2 of the ceramic sintered body 3. The second circuit plate 4' is a single plate member.

The coverage of the second main surface F2 by the second circuit plate 4' is not particularly limited but can be, for example, 90% or more and 96% or less. The coverage of the second main surface F2 by the second circuit plate 4' is obtained by dividing the total area of the second circuit plate 4' by the total area of the second main surface F2 in the plan view of the semiconductor device substrate 2. The coverage of the second main surface F2 by the second circuit plate 4' may be the same as the coverage of the first main surface F1 by the first circuit plate 4 or may be larger than the coverage of the first main surface F1 by the first circuit plate 4. The total area of the second circuit plate 4' may be the same as the total area of the first circuit plate 4 or may be larger than the total area of the first circuit plate 4.

The method for manufacturing the semiconductor device substrate 2 is not particularly limited, and for example, it can be manufactured as follows. First, a laminated body is formed in which the first circuit plate 4 is arranged on the first main surface F1 side of the ceramic sintered body 3 and the second circuit plate 4' is arranged on the second main surface F2 side of the ceramic sintered body 3. Next, the laminate is heated for about 10 minutes under nitrogen atmosphere conditions of 1070 degrees C to 1075 degrees C. As a result, a Cu-O eutectic liquid phase is generated at the interface where the ceramic sintered body 3 and the first and second circuit plates 4 and 4' are bonded (hereinafter, collectively referred to as "bonding interface"), and the first and second main surfaces F1 and F2 of the sintered body 3 get wet. Next, the Cu-O eutectic liquid phase is solidified by cooling the laminate, and the first and second copper plates 4 and 4' are bonded to the ceramic sintered body 3.

The first copper plate 4 on which a transmission circuit is formed is bonded to the surface of the ceramic sintered body 3 in the semiconductor device substrate 2. The transmission circuit may be formed by a subtractive method or an additive method.

The semiconductor chip 6 is bonded to the first circuit plate 4. The bonding wire 7 connects the semiconductor chip 6 and the first circuit plate 4.

The heat sink 8 is bonded to the second circuit plate 4'. The heat sink 8 absorbs the heat of the semiconductor chip 6 transmitted via the semiconductor device substrate 2. The heat sink 8 can be constituted of, for example, copper or the like. The size and shape of the heat sink 8 are not particularly limited.

The heat radiating portion 9 is attached to the heat sink 8. The heat radiating portion 9 radiates the heat of the semiconductor chip 6 transmitted via the semiconductor device substrate 2 and the heat sink 8 to the outside air. The heat radiating portion 9 can be constituted of, for example, aluminum or the like. The size and shape of the heat radiating portion 9 are not particularly limited. The heat radiating portion 9 preferably includes a plurality of fin portions 9a. As a result, it is possible to improve the heat radiating efficiency of the heat radiating portion 9.

The plane size and plane shape of the heat sink 8 and the heat radiating portion 9 are not particularly limited but may be, for example, a square or rectangle having a vertical length P2 of 25 to 40 mm and a horizontal length Q2 of 35 to 50 mm.

(Constituent elements of ceramic sintered body 3)

The ceramic sintered body 3 contains Al (aluminum), Zr (zirconium), Y (yttrium), and Mg (magnesium).

The Al content in the ceramic sintered body 3 can be 75 mass% or more and 92.5 mass% or less in terms of $Al_2O_3$. The Al content in the ceramic sintered body 3 is preferably 75 mass% or more and 85 mass% or less in terms of $Al_2O_3$.

The Zr content (described later, S2) in the ceramic sintered body 3 can be 5 mass% or more and 27.5 mass% or less in terms of $ZrO_2$ and is preferably 7.5 mass% or more and 25 mass% or less in terms of $ZrO_2$ and further preferably 17.5 mass% or more and 23.5 mass% or less in terms of $ZrO_2$.

It is considered that by setting the Zr content to 7.5 mass% or more in terms of $ZrO_2$, it is possible to prevent the linear thermal expansion coefficient $\alpha$ of the ceramic sintered body 3 from becoming too small, and it is possible to reduce the difference in the linear thermal expansion coefficient of the ceramic sintered body 3 and the first and second circuit plates 4 and 4'. As a result, it is considered that it contributes to prevent cracks from occurring at the bonding interface. This effect can be further improved by setting the Zr content to 17.5 mass% or more in terms of $ZrO_2$.

It is considered that by setting the Zr content to 25 mass% or less in terms of $ZrO_2$, it is possible to prevent an excessive reaction at the bonding interface at the time of circuit plate bonding, and it is possible to prevent voids from forming at the bonding interface. As a result, it is considered that it contributes to prevent cracks at the bonding interface. This effect can be further improved by setting the Zr content to 23.5 mass% or less in terms of $ZrO_2$.

The Y content in the ceramic sintered body 3 can be 0.3 mass% or more and 2.0 mass% or less in terms of $Y_2O_3$. The Y content in the ceramic sintered body 3 is preferably 0.7 mass% or more and 2.0 mass% or less in terms of $Y_2O_3$.

It is considered that by setting the Y content to 0.3 mass% or more in terms of $Y_2O_3$, it is possible to prevent the peak intensity ratio of the monoclinic crystal phase from being excessive among the $ZrO_2$ crystal phases contained in the ceramic sintered body 3 as the crystal phase. As a result, it is considered that the mechanical strength of the ceramic sintered body 3 can be improved, so that it contributes to prevent cracks from occurring at the bonding interface.

It is considered that by setting the Y content to 2.0 mass% or less in terms of $Y_2O_3$, it is possible to prevent the peak intensity ratio of the monoclinic crystal phase from being too small among the $ZrO_2$ crystal phases contained in the ceramic sintered body 3 as the crystal phase. As a result, it is considered that the mechanical strength of the ceramic sintered body 3 can be improved, so that it contributes to prevent cracks from occurring at the bonding interface.

The Mg content (S1 described later) in the ceramic sintered body 3 can be larger than 0.08 mass% and less than 1.18 mass% in terms of MgO.

It is considered that by increasing the Mg content to more than 0.08 mass% in terms of MgO, it is possible to sinter the ceramic sintered body 3 without excessively raising the firing temperature, and it is possible to prevent $Al_2O_3$ particles and $ZrO_2$ particles from coarsening. As a result, it is considered that the mechanical strength of the ceramic sintered body 3 can be improved, so that contributes to prevent cracks from occurring at the bonding interface. Further, it is considered that it is possible to generate a sufficient amount of $MgAl_2O_4$ (spinel) crystals in the ceramic sintered body 3, and it is possible to improve the wettability with the Cu-O eutectic liquid phase at the time of bonding the circuit plate. As a result, it is considered that it contributes to prevent voids from occurring at the bonding interface.

It is considered that by setting the Mg content to less than 1.18 mass% in terms of MgO, it is possible to prevent excessive growth of alumina and zirconia crystals and improve the mechanical strength of the ceramic sintered body 3. As a result, it is considered that it contributes to prevent cracks from occurring at the bonding interface. Further, it is considered that it is possible to prevent the excessive generation of $MgAl_2O_4$ crystals in the ceramic sintered body 3 and prevent the excessive reaction at the bonding interface at the time of circuit plate bonding. As a result, it is considered that it contributes to prevent voids from generating at the bonding interface.

The ceramic sintered body 3 may contain at least one of Hf (hafnium), Si (silicon), Ca (calcium), Na (sodium) and K (potassium), and the balance other than these. The element contained in the balance may be an element that is intentionally added or an element that is unavoidably mixed. Although the elements contained in the balance are not particularly limited, examples thereof include Fe (iron), Ti (titanium), Mn (manganese), or the like.

Although in the present embodiment, the content of the constituent elements of the ceramic sintered body 3 is calculated in terms of oxide as described above, the constituent elements of the ceramic sintered body 3 may or may not exist in the form of oxide. For example, at least one of Y, Mg and Ca may not exist in the form of an oxide and may be dissolved in ZrO2.

Note that the content of the constituent elements of the ceramic sintered body 3 in terms of oxide is calculated as follows. First, the constituent elements of the ceramic sintered body 3 are qualitatively analyzed using an energy dispersive analyzer (EDS) attached to a fluorescent X-ray analyzer (XRF) or a scanning electron microscope (SEM). Next, each element detected by this qualitative analysis is quantitatively analyzed using an ICP emission spectroscopic analyzer. Next, the content of each element measured by this quantitative analysis is converted into an oxide.

(Composition of ceramic sintered body 3 and thickness of each component)

Next, the combination of the composition of the ceramic sintered body 3 and the thicknesses of the ceramic sintered body 3, the first circuit plate 4 and the second circuit plate 4' will be described.

When the Mg content in the ceramic sintered body 3 in terms of MgO is S1 mass% and the Zr content in terms of $ZrO_2$ is S2 mass%, the following formula (1) is established.

$$-0.004 \times S2 + 0.171 < S1 < -0.032 \times S2 + 1.427 \cdots (1)$$

When the thickness of the first circuit plate is T1 mm, the thickness of the second circuit plate is T2 mm, and the thickness of the ceramic sintered body is T3 mm, the following formulas (2), (3), (4) are established.

$$1.7 < (T1 + T2) / T3 < 3.5 \cdots (2)$$

$$T1 \geq T2 \cdots (3)$$

$$T3 \geq 0.25 \cdots (4)$$

By establishing the above formulas (1) to (4), it is possible to prevent cracks from occurring at the bonding interface even if the ceramic sintered body 3 is subjected to a thermal cycle and also decrease the heat resistance rate of the semiconductor device substrate 2 as a whole. Although the mechanism by which such an effect is obtained is not always clear, it is considered to be a synergistic effect of that the mechanical strength of the ceramic sintered body 3 is increased by satisfying upper limit value of the formulas (1) and (2) and the formula (4) and that the optimization of the relative thickness of the ceramic sintered body 3 having a low thermal conductivity and the first and second circuit plates 4 and 4' having a high thermal conductivity by satisfying the lower limit value of the formula (2) and the formula (3).

As illustrated in the formula (3), the thickness T1 mm of the first circuit plate may be the same as the thickness T2 mm of the second circuit plate or may be larger than the thickness T2 mm of the second circuit plate. However, if the total area of the second circuit plate 4' is larger than the total area of the first circuit plate 4, the ceramic sintered body 3 may be deformed concavely toward the second circuit plate 4' at the time of bonding the circuit plates. Therefore, when the total area of the second circuit plate 4' is larger than the total area of the first circuit plate 4, the thickness T1 mm of the first circuit plate is preferably larger than the thickness T2 mm of the second circuit plate.

Regarding the content S2 of Zr in the ceramic sintered body 3 in terms of $ZrO_2$, it is preferable that the following formula (5) is established.

$$7.5 \leq S2 \leq 25 \cdots (5)$$

By establishing the formula (5), as described above, it is possible to further increase the mechanical strength of the ceramic sintered body, so that it is possible to further prevent cracks from occurring at the bonding interface.

Regarding the Zr content S2 in the ceramic sintered body 3 in terms of $ZrO_2$, it is more preferable that the following formula (6) is established.

$$17.5 \leq S2 \leq 23.5 \cdots (6)$$

By establishing the formula (6), it is possible to further increase the mechanical strength of the ceramic sintered body 3, so that it is possible to prevent cracks from occurring at the bonding interface.

Regarding the Mg content S1 in the ceramic sintered body 3 in terms of MgO, it is more preferable that the following formula (7) is established.

$$0.08 < S1 < 1.18 \cdots (7)$$

By establishing the formula (7), as described above, it is possible to further increase the mechanical strength of the ceramic sintered body 3, so that it is possible to prevent cracks from occurring at the bonding interface.

(Manufacturing method of ceramic sintered body 3)

With reference to FIG. 2, a method for manufacturing the ceramic sintered body 3 will be described. FIG. 2 is a flowchart showing a method for manufacturing the ceramic sintered body 3.

In step S1, in addition to $Al_2O_3$, $ZrO_2$, $Y_2O_3$ and MgO, powder materials such as $HfO_2$, $SiO_2$, CaO, $Na_2O$, $K_2O$ or the like are prepared as desired.

Note that although each of $ZrO_2$ and $Y_2O_3$ may be a single powder material, a powder material of $ZrO_2$ partially stabilized by $Y_2O_3$ may be used. Further, Mg, Ca, and alkali metals (Na and K) may be carbonate powders.

In step S2, the prepared powder material is pulverized and mixed by, for example, a ball mill.

In step S3, an organic binder (for example, polyvinyl butyral), a solvent (xylene, toluene, or the like) and a plasticizer (dioctyl phthalate) are added to the pulverized and mixed powder material to form a slurry-like substance.

In step S4, the slurry-like substance is molded into a desired shape by a desired molding means (for example, mold press, cold hydrostatic press, injection molding, doctor blade method, extrusion molding method, or the like) to form a ceramic molded product. At this time, in order to establish the above formulas (2) to (4) regarding the thickness T3 of the ceramic sintered body 3 in relation to the thickness T1 of the first circuit plate and the thickness T2 of the second circuit plate, the thickness of the ceramic molded body is adjusted in consideration of the firing shrinkage rate in step S5.

In step S5, the ceramic molded product is fired in an oxygen atmosphere or an air atmosphere (at 1600 degrees C to 1620 degrees C, 0.7 hours to 1.0 hours).

[Example]

As Sample Nos. 1 to 72, the semiconductor device 1 including the configurations illustrated in FIGS. 1 and 2 was manufactured, and the thermal resistance of the semiconductor device 1 and the number of thermal cycles in which cracks were generated were measured.

(Manufacturing of semiconductor device 1)

First, powder materials of $Al_2O_3$, $ZrO_2$, $Y_2O_3$ and MgO were prepared, and the powder materials were pulverized and mixed by a ball mill. At this time, the $ZrO_2$ content S2 and the MgO content S1 were changed for each sample as illustrated in Table 1, and the balance was regarded as $Al_2O_3$.

Next, polyvinyl butyral as an organic binder, xylene as a solvent, and dioctyl phthalate as a plasticizer were added to the pulverized and mixed powder material to form a slurry-like substance.

Next, a ceramic molded body was produced by molding a slurry-like substance into a sheet by the doctor blade method. At this time, by changing the gate height of the blade, the thickness of the ceramic molded body was adjusted for each sample so that the thickness T3 of the ceramic sintered body 3 became the value illustrated in Table 1.

Next, the ceramic molded product was fired in an air atmosphere (at 1600 degrees C, to 0.8 hours) to prepare a ceramic sintered body 3. The vertical length P1 of the ceramic sintered body 3 was 40 mm, and the horizontal length Q1 was 40 mm.

Next, the first circuit plate 4 constituted of oxygenfree copper conforming to JIS C1020 (one sheet having a vertical length of 37.4 mm × a horizontal length of 19.8 mm and two sheets having a vertical length of 37.4 mm × a horizontal length of 7.8 mm) and the second circuit plate 4' (one sheet having a vertical length of 37.4 mm and a horizontal length of 37.4 mm) were prepared. The thickness T1 of the first circuit plate 4 and the thickness T2 of the second circuit plate 4' were different for each sample as illustrated in Table 1.

Next, the outer surfaces of the first and second circuit plates 4 and 4' were oxidized by heating to 300 degrees C in the atmosphere.

Next, the laminate in which the ceramic sintered body 3 was sandwiched between the first and second circuit plates 4, 4' was heated at 1070 degrees C for 10 minutes in the nitrogen ($N_2$) atmosphere.

Next, the first and second circuit plates 4, 4' were bonded to the ceramic sintered body 3 by cooling the laminate. The coverage of the first main surface F1 by the first circuit plate 4 was 82.7%, and the coverage of the second main surface F2 by the second circuit plate 4' was 87.4%.

Next, by using solder, a copper heat sink 8 (length 60 mm × width 60 mm × thickness 3 mm) to which an aluminum heat sink 9 (length 60 mm × width 60 mm × thickness 6.5 mm) is attached was bonded to the second circuit plate 4'.

Next, by using solder, the Si semiconductor chip 6 is bonded to the first circuit plate 4, and also the bonding wire 7 was attached to the Si semiconductor chip 6 (length 10 mm × width 10 mm × thickness 0.35 mm) and the first circuit plate 4.

(Measurement of thermal resistance)

Regarding sample Nos. 1 to 72, the thermal resistance $R_{J-a}$ (degrees C/W) of the semiconductor device 1 was measured from the following formula (8) by energizing the Si semiconductor chip 6 and generating heat. However, in the formula (8), $T_j$ is the element temperature (degrees C) of the Si semiconductor chip 6, Ta is the ambient temperature (degrees C) of the Si semiconductor chip 6, and Q is the electric power (W) supplied to the Si semiconductor chip 6.

$$R_{J-a} = (T_j - T_a) / Q \cdots (8)$$

In Table 1, regarding each of sample Nos. 1 to 72, the average value of the thermal resistance of 10 pieces is described. In Table 1, samples having a thermal resistance (degrees C/W) of 0.805 or more is evaluated as "x", and samples having a thermal resistance of 0.790 or more and 0.805 or less is evaluated as "Δ", and samples having a thermal resistance of 0.790 or less is evaluated as "o".

(Crack occurrence rate)

Regarding sample Nos. 1 to 72, the cycle of "first at -40 degrees C for 30 minutes, secondly at 25 degrees C for 5 minutes, thirdly at 125 degrees C for 30 minutes, and finally at 25 degrees C for 5 minutes" was repeated until cracks occurred in the ceramic sintered body 3.

In Table 1, regarding each of sample Nos. 1 to 72, the number of cycles in which cracks occur in any of the 10 pieces is described as the number of crack generation cycles. In Table 1, samples having 51 or more crack generation cycles (times) are evaluated as "o", samples having 31 or more and 50 or less are evaluated as "Δ", and samples having 30 or less are evaluated as "x" .

[Table 1]

| Sample | Ceramic sintered body composition | | Range of formula (1) | | Substrate for semiconductor device | | | | Characterization | | | | Evaluated results |
|---|---|---|---|---|---|---|---|---|---|---|---|---|---|
| | S1:MgO (mass%) | S2:ZrO$_2$ (mass%) | -0.004×S2+0.171 (mass %) | -0.032×S2+1.427 (mass%) | T1 (mm) | T2 (mm) | T3 (mm) | (T1+T2)/T3 | Thermal resistance (degrees C/W) | | Number of crack generation cycles | | |
| No.1 | 0.52 | 5 | 0.15 | 1.27 | 0.30 | 0.30 | 0.25 | 2.40 | 0.768 | ○ | 35 | △ | △ |
| No.2 | 0.13 | 7.5 | 0.14 | 1.19 | 0.30 | 0.30 | 0.25 | 2.40 | 0.770 | ○ | 25 | × | × |
| No.3 | 0.16 | 7.5 | 0.14 | 1.19 | 0.30 | 0.30 | 0.25 | 2.40 | 0.770 | ○ | 35 | △ | △ |
| No.4 | 1.17 | 7.5 | 0.14 | 1.19 | 0.30 | 0.30 | 0.25 | 2.40 | 0.770 | ○ | 40 | △ | △ |
| No.5 | 1.20 | 7.5 | 0.14 | 1.19 | 0.30 | 0.30 | 0.25 | 2.40 | 0.770 | ○ | 30 | × | × |
| No.6 | 0.53 | 7.5 | 0.14 | 1.19 | 0.20 | 0.20 | 0.32 | 1.25 | 0.806 | × | 40 | △ | × |
| No.7 | 0.53 | 7.5 | 0.14 | 1.19 | 0.30 | 0.30 | 0.32 | 1.88 | 0.787 | ○ | 35 | △ | △ |
| No.8 | 0.53 | 7.5 | 0.14 | 1.19 | 0.30 | 0.30 | 0.25 | 2.40 | 0.770 | ○ | 55 | ○ | ○ |
| No.9 | 0.53 | 7.5 | 0.14 | 1.19 | 0.50 | 0.50 | 0.32 | 3.13 | 0.763 | ○ | 40 | △ | △ |
| No.10 | 0.53 | 7.5 | 0.14 | 1.19 | 0.60 | 0.60 | 0.32 | 3.75 | 0.753 | ○ | 30 | × | × |
| No.11 | 0.53 | 7.5 | 0.14 | 1.19 | 0.10 | 0.10 | 0.20 | 1.00 | 0.813 | × | 35 | △ | × |
| No. 12 | 0.12 | 10 | 0.13 | 1.11 | 0.30 | 0.30 | 0.25 | 2.40 | 0.772 | ○ | 30 | × | × |
| No. 13 | 0.15 | 10 | 0.13 | 1.11 | 0.30 | 0.30 | 0.25 | 2.40 | 0.772 | ○ | 35 | △ | △ |
| No. 14 | 1.09 | 10 | 0.13 | 1.11 | 0.30 | 0.30 | 0.25 | 2.40 | 0.772 | ○ | 40 | △ | △ |
| No. 15 | 1.12 | 10 | 0.13 | 1.11 | 0.30 | 0.30 | 0.25 | 2.40 | 0.772 | ○ | 30 | × | × |
| No. 16 | 0.50 | 10 | 0.13 | 1.11 | 0.20 | 0.20 | 0.32 | 1.25 | 0.809 | × | 45 | △ | × |
| No. 17 | 0.50 | 10 | 0.13 | 1.11 | 0.30 | 0.30 | 0.32 | 1.88 | 0.790 | △ | 50 | △ | △ |
| No. 18 | 0.50 | 10 | 0.13 | 1.11 | 0.30 | 0.30 | 0.25 | 2.40 | 0.772 | ○ | 55 | ○ | ○ |
| No. 19 | 0.50 | 10 | 0.13 | 1.11 | 0.50 | 0.50 | 0.32 | 3.13 | 0.765 | ○ | 40 | △ | △ |
| No.20 | 0.50 | 10 | 0.13 | 1.11 | 0.60 | 0.60 | 0.32 | 3.75 | 0.755 | ○ | 30 | × | × |
| No.21 | 0.50 | 10 | 0.13 | 1.11 | 0.10 | 0.10 | 0.20 | 1.00 | 0.817 | × | 40 | △ | × |

| Sample | Ceramic sintered body composition | | Range of formula (1) | | Substrate for semiconductor device | | | | Characterization | | | | Evaluated results |
|---|---|---|---|---|---|---|---|---|---|---|---|---|---|
| | S1:MgO (mass%) | S2:ZrO$_2$ (mass%) | -0.004×S2+0.171 (mass %) | -0.032×S2+1.427 (mass%) | T1 (mm) | T2 (mm) | T3 (mm) | (T1+T2) /T3 | Thermal resistance (degrees C/W) | | Number of crack generation cycles | | |
| No.22 | 0.10 | 15 | 0.11 | 0.95 | 0.30 | 0.30 | 0.25 | 2.40 | 0.777 | ○ | 30 | × | × |
| No.23 | 0.13 | 15 | 0.11 | 0.95 | 0.30 | 0.30 | 0.25 | 2.40 | 0.777 | ○ | 60 | ○ | ○ |
| No.24 | 0.93 | 15 | 0.11 | 0.95 | 0.30 | 0.30 | 0.25 | 2.40 | 0.777 | ○ | 70 | ○ | ○ |
| No.25 | 0.96 | 15 | 0.11 | 0.95 | 0.30 | 0.30 | 0.25 | 2.40 | 0.777 | ○ | 25 | × | × |
| No.26 | 0.42 | 15 | 0.11 | 0.95 | 0.20 | 0.20 | 0.32 | 1.25 | 0.813 | × | 80 | ○ | × |
| No.27 | 0.42 | 15 | 0.11 | 0.95 | 0.30 | 0.30 | 0.32 | 1.88 | 0.796 | △ | 70 | ○ | ○ |
| No.28 | 0.42 | 15 | 0.11 | 0.95 | 0.30 | 0.30 | 0.25 | 2.40 | 0.777 | ○ | 60 | ○ | ○ |
| No.29 | 0.42 | 15 | 0.11 | 0.95 | 0.50 | 0.50 | 0.32 | 3.13 | 0.770 | ○ | 55 | ○ | ○ |
| No.30 | 0.42 | 15 | 0.11 | 0.95 | 0.60 | 0.60 | 0.32 | 3.75 | 0.760 | ○ | 30 | × | × |
| No.31 | 0.42 | 15 | 0.11 | 0.95 | 0.10 | 0.10 | 0.20 | 1.00 | 0.825 | × | 55 | ○ | × |
| No.32 | 0.09 | 17.5 | 0.10 | 0.87 | 0.30 | 0.30 | 0.25 | 2.40 | 0.780 | ○ | 30 | × | × |
| No.33 | 0.12 | 17.5 | 0.10 | 0.87 | 0.30 | 0.30 | 0.25 | 2.40 | 0.780 | ○ | 125 | ◎ | ◎ |
| No.34 | 0.85 | 17.5 | 0.10 | 0.87 | 0.30 | 0.30 | 0.25 | 2.40 | 0.780 | ○ | 150 | ◎ | ◎ |
| No.35 | 0.88 | 17.5 | 0.10 | 0.87 | 0.30 | 0.30 | 0.25 | 2.40 | 0.780 | ○ | 30 | × | × |
| No.36 | 0.39 | 17.5 | 0.10 | 0.87 | 0.20 | 0.20 | 0.32 | 1.25 | 0.815 | × | 90 | ○ | × |
| No.37 | 0.39 | 17.5 | 0.10 | 0.87 | 0.30 | 0.30 | 0.32 | 1.88 | 0.798 | △ | 125 | ◎ | ◎ |
| No.38 | 0.39 | 17.5 | 0.10 | 0.87 | 0.30 | 0.30 | 0.25 | 2.40 | 0.780 | ○ | 125 | ◎ | ◎ |
| No.39 | 0.39 | 17.5 | 0.10 | 0.87 | 0.50 | 0.50 | 0.32 | 3.13 | 0.773 | ○ | 125 | ◎ | ◎ |
| No.40 | 0.39 | 17.5 | 0.10 | 0.87 | 0.60 | 0.60 | 0.32 | 3.75 | 0.762 | ○ | 30 | × | ◎ |
| No.41 | 0.50 | 17.5 | 0.10 | 0.87 | 0.10 | 0.10 | 0.20 | 1.00 | 0.828 | × | 100 | ○ | × |
| No.42 | 0.08 | 20 | 0.09 | 0.79 | 0.30 | 0.30 | 0.25 | 2.40 | 0.784 | ○ | 25 | × | × |

EP 3 855 484 B1

(continued)

| Sample | Ceramic sintered body composition | | Range of formula (1) | | Substrate for semiconductor device | | | | Characterization | | | | Evaluated results |
|---|---|---|---|---|---|---|---|---|---|---|---|---|---|
| | S1:MgO (mass%) | S2:ZrO₂ (mass%) | $-0.004 \times S2 + 0.171$ (mass %) | $-0.032 \times S2 + 1.427$ (mass%) | T1 (mm) | T2 (mm) | T3 (mm) | (T1+T2)/T3 | Thermal resistance (degrees C/W) | | Number of crack generation cycles | | |
| No.43 | 0.11 | 20 | 0.09 | 0.79 | 0.30 | 0.30 | 0.25 | 2.40 | 0.784 | ○ | 175 | ◎ | ◎ |
| No.44 | 0.77 | 20 | 0.09 | 0.79 | 0.30 | 0.30 | 0.25 | 2.40 | 0.784 | ○ | 150 | ◎ | ◎ |
| No.45 | 0.80 | 20 | 0.09 | 0.79 | 0.30 | 0.30 | 0.25 | 2.40 | 0.784 | ○ | 30 | × | × |
| No.46 | 0.35 | 20 | 0.09 | 0.79 | 0.20 | 0.20 | 0.32 | 1.25 | 0.820 | × | 125 | ◎ | × |
| No.47 | 0.35 | 20 | 0.09 | 0.79 | 0.30 | 0.30 | 0.32 | 1.88 | 0.800 | △ | 125 | ◎ | ◎ |
| No.48 | 0.35 | 20 | 0.09 | 0.79 | 0.30 | 0.30 | 0.25 | 2.40 | 0.784 | ○ | 175 | ◎ | ◎ |
| No.49 | 0.35 | 20 | 0.09 | 0.79 | 0.50 | 0.50 | 0.32 | 3.13 | 0.777 | ○ | 125 | ◎ | ◎ |
| No.50 | 0.35 | 20 | 0.09 | 0.79 | 0.60 | 0.60 | 0.32 | 3.75 | 0.766 | ○ | 30 | × | × |
| No.51 | 0.35 | 20 | 0.09 | 0.79 | 0.10 | 0.10 | 0.20 | 1.00 | 0.832 | × | 125 | ◎ | × |
| No.52 | 0.07 | 23.5 | 0.08 | 0.68 | 0.30 | 0.30 | 0.25 | 2.40 | 0.787 | ○ | 30 | × | × |
| No.53 | 0.10 | 23.5 | 0.08 | 0.68 | 0.30 | 0.30 | 0.25 | 2.40 | 0.787 | ○ | 150 | ◎ | ◎ |
| No.54 | 0.66 | 23.5 | 0.08 | 0.68 | 0.30 | 0.30 | 0.25 | 2.40 | 0.787 | ○ | 150 | ◎ | ◎ |
| No.55 | 0.69 | 23.5 | 0.08 | 0.68 | 0.30 | 0.30 | 0.25 | 2.40 | 0.787 | ○ | 30 | × | × |
| No.56 | 0.30 | 23.5 | 0.08 | 0.68 | 0.20 | 0.20 | 0.32 | 1.25 | 0.823 | × | 100 | ○ | × |
| No.57 | 0.30 | 23.5 | 0.08 | 0.68 | 0.30 | 0.30 | 0.32 | 1.88 | 0.802 | △ | 125 | ◎ | ◎ |
| No.58 | 0.30 | 23.5 | 0.08 | 0.68 | 0.30 | 0.30 | 0.25 | 2.40 | 0.787 | ○ | 150 | ◎ | ◎ |
| No.59 | 0.30 | 23.5 | 0.08 | 0.68 | 0.50 | 0.50 | 0.32 | 3.13 | 0.780 | ○ | 125 | ◎ | ◎ |
| No.60 | 0.30 | 23.5 | 0.08 | 0.68 | 0.60 | 0.60 | 0.32 | 3.75 | 0.768 | ○ | 25 | × | × |
| No.61 | 0.50 | 23.5 | 0.08 | 0.68 | 0.10 | 0.10 | 0.20 | 1.00 | 0.835 | × | 80 | ○ | × |
| No.62 | 0.06 | 25 | 0.07 | 0.63 | 0.30 | 0.30 | 0.25 | 2.40 | 0.791 | △ | 30 | × | × |
| No.63 | 0.09 | 25 | 0.07 | 0.63 | 0.30 | 0.30 | 0.25 | 2.40 | 0.791 | △ | 60 | ○ | ○ |

(continued)

| Sample | Ceramic sintered body composition | | Range of formula (1) | | Substrate for semiconductor device | | | | Characterization | | | | Evaluated results |
|---|---|---|---|---|---|---|---|---|---|---|---|---|---|
| | S1:MgO (mass%) | S2:ZrO$_2$ (mass%) | -0.004×S2+0.171 (mass %) | -0.032×S2+1.427 (mass%) | T1 (mm) | T2 (mm) | T3 (mm) | (T1+T2) /T3 | Thermal resistance (degrees C/W) | | Number of crack generation cycles | | |
| No.64 | 0.61 | 25 | 0.07 | 0.63 | 0.30 | 0.30 | 0.25 | 2.40 | 0.791 | △ | 70 | ○ | ○ |
| No.65 | 0.64 | 25 | 0.07 | 0.63 | 0.30 | 0.30 | 0.25 | 2.40 | 0.791 | △ | 30 | × | × |
| No.66 | 0.28 | 25 | 0.07 | 0.63 | 0.20 | 0.20 | 0.32 | 1.25 | 0.827 | × | 55 | ○ | × |
| No.67 | 0.28 | 25 | 0.07 | 0.63 | 0.30 | 0.30 | 0.32 | 1.88 | 0.804 | △ | 60 | ○ | ○ |
| No.68 | 0.28 | 25 | 0.07 | 0.63 | 0.30 | 0.30 | 0.25 | 2.40 | 0.791 | △ | 80 | ○ | ○ |
| No.69 | 0.28 | 25 | 0.07 | 0.63 | 0.50 | 0.50 | 0.32 | 3.13 | 0.784 | ○ | 55 | ○ | ○ |
| No.70 | 0.28 | 25 | 0.07 | 0.63 | 0.60 | 0.60 | 0.32 | 3.75 | 0.772 | ○ | 25 | × | × |
| No.71 | 0.28 | 25 | 0.07 | 0.63 | 0.10 | 0.10 | 0.20 | 1.00 | 0.842 | × | 60 | ○ | × |
| No.72 | 0.22 | 27.5 | 0.06 | 0.55 | 0.30 | 0.30 | 0.25 | 2.40 | 0.795 | △ | 35 | △ | △ |

As illustrated in Table 1, in the samples in which all of the above formulas (1) to (4) were established, it was possible to prevent cracks from occurring at the bonding interface even if the ceramic sintered body 3 was subjected to a thermal cycle, and also the thermal resistivity of the semiconductor device substrate 2 as a whole could be reduced.

On the other hand, at the sample Nos. 2, 5, 12, 15, 22, 25, 32, 35, 42, 45, 52, 55, 62, and 65 which do not satisfy the formula (1), the mechanical strength of the ceramic sintered body 3 was not sufficient, so that cracks were likely to occur at the bonding interface. Further, at the sample Nos. 10, 20, 30, 40, 50, 60, and 70 which do not satisfy upper limit value of the formula (2), the mechanical strength of the ceramic sintered body 3 was not sufficient, so that cracks were likely to occur at the bonding interface. In addition, at the sample Nos. 6, 11, 16, 21, 26, 31, 36, 41, 46, 51, 56, 61, 77, and 71 which do not satisfy the lower limit of the formula (2), the relative thickness with respect to the ceramic sintered body 3 having a low thermal conductivity and the first and second circuit plates 4 and 4' having a high thermal conductivity was not optimized, so that the thermal conductivity of the semiconductor device substrate 2 as a whole was high.

In addition, according to comparing sample No. 1 and sample Nos. 8 and 18, in the sample in which the above-mentioned formula (5) is established, it was possible to further prevent cracks from occurring at the bonding interface between the ceramic sintered body 3 and the first and second circuit plates 4, 4'.

Further, in the sample in which the above-mentioned formula (6) is established, it was possible to further prevent cracks from occurring at the bonding interface between the ceramic sintered body 3 and the first and second circuit plates 4, 4'. Note that this effect could be particularly improved in the samples in which the content of Zr in terms of $ZrO_2$ was 17.5 mass% or more and 23.5 mass% or less.

INDUSTRIAL APPLICABILITY

According to the present invention, it is possible to both reduce the thermal resistance of the semiconductor device substrate and prevent cracks at the same time. Therefore, the semiconductor device substrate according to the present invention can be used in various electronic devices.

REFERENCE SIGNS LIST

| 1 | Semiconductor device |
| 2 | Substrate for semiconductor device |
| 3 | Ceramic sintered body |
| 4, 4 | Copper plate |
| 6 | Semiconductor chip |
| 7 | Bonding wire |
| 8 | Heat sink |
| 9 | Heat radiating portion |

**Claims**

1. A substrate for semiconductor device comprising:

a ceramic sintered body formed in a plate shape and including a first main surface and a second main surface;
a first circuit plate arranged on the first main surface and constituted of copper or aluminum; and
a second circuit plate arranged on the second main surface and constituted of copper or aluminum, wherein the ceramic sintered body contains Al, Zr, Y and Mg;
when the Mg content in terms of MgO in the ceramic sintered body is S1 mass% and the Zr content in terms of $ZrO_2$ in the ceramic sintered body is S2 mass%, a following formula (1) is established; and
when a thickness of the first circuit plate is T1 mm, a thickness of the second circuit plate is T2 mm, and a thickness of the ceramic sintered body is T3 mm, following formulas (2), (3), and (4) are established.

$$-0.004 \times S2 + 0.171 < S1 < -0.032 \times S2 + 1.427 \cdots (1)$$

$$1.7 < (T1 + T2) / T3 < 3.5 \cdots (2)$$

$$T1 \geq T2 \cdots (3)$$

$$T3 \geq 0.25 \cdots (4)$$

2. The substrate for a semiconductor device according to claim 1, wherein in the ceramic sintered body, a following formula (5) is established.

$$7.5 \leq S2 \leq 25 \cdots (5)$$

3. The substrate for a semiconductor device according to claim 1, wherein in the ceramic sintered body, a following formula (6) is established.

$$17.5 \leq S2 \leq 23.5 \cdots (6)$$

4. The substrate for a semiconductor device according to any one of claims 1 to 3, wherein in the ceramic sintered body, a following formula (7) is established.

$$0.08 < S1 < 1.18 \cdots (7)$$

**Patentansprüche**

1. Substrat für eine Halbleitervorrichtung, umfassend:

einen keramischen Sinterkörper, der in einer Plattenform ausgebildet ist und eine erste Hauptoberfläche und eine zweite Hauptoberfläche einschließt;
eine erste Schaltungsplatte, die auf der ersten Hauptoberfläche angeordnet ist und aus Kupfer oder Aluminium aufgebaut ist; und
eine zweite Schaltungsplatte, die auf der zweiten Hauptoberfläche angeordnet ist und aus Kupfer oder Aluminium aufgebaut ist, wobei
der keramische Sinterkörper Al, Zr, Y und Mg enthält;
wenn der Mg-Gehalt in Bezug auf MgO in dem keramischen Sinterkörper S1 Massen-% ist und der Zr-Gehalt in Bezug auf $ZrO_2$ in dem keramischen Sinterkörper S2 Massen-% ist, eine folgende Formel (1) gilt; und
wenn eine Dicke der ersten Schaltungsplatte T1 mm ist, eine Dicke der zweiten Schaltungsplatte T2 mm ist und eine Dicke des keramischen Sinterkörpers T3 mm ist, die folgenden Formeln (2), (3) und (4) gelten.

$$-0,004 \ x \ S2 + 0,171 < S1 < -0,032 \ x \ S2 + 1,427 \cdots (1)$$

$$1,7 < (T1 + T2) \ / \ T3 < 3,5 \cdots (2)$$

$$T1 \geq T2 \cdots (3)$$

$$T3 \geq 0,25 \cdots (4)$$

2. Substrat für eine Halbleitervorrichtung nach Anspruch 1, wobei in dem keramischen Sinterkörper eine folgende Formel (5) gilt.

$$7,5 \leq S2 \leq 25 \cdots (5)$$

**3.** Substrat für eine Halbleitervorrichtung nach Anspruch 1, wobei
in dem keramischen Sinterkörper eine folgende Formel (6) gilt.

$$17,5 \leq S2 \leq 23,5 \cdots (6)$$

**4.** Substrat für eine Halbleitervorrichtung nach einem der Ansprüche 1 bis 3 , wobei
in dem keramischen Sinterkörper eine folgende Formel (7) gilt.

$$0,08 < S1 < 1,18 \cdots (7)$$

**Revendications**

**1.** Substrat pour dispositif à semi-conducteur comprenant :

un corps fritté en céramique formé en une forme de plaque et incluant une première surface principale et une seconde surface principale ;
une première plaque de circuit agencée sur la première surface principale et
constituée de cuivre ou d'aluminium ; et
une seconde plaque de circuit agencée sur la seconde surface principale et constituée de cuivre ou d'aluminium, dans lequel
le corps fritté en céramique contient Al, Zr, Y et Mg ;
lorsque la teneur en Mg en termes de MgO dans le corps fritté en céramique est S1 % en masse et la teneur en Zr en termes de $ZrO_2$ dans le corps fritté en céramique est S2 % en masse, une formule (1) suivante est établie ; et
lorsqu'une épaisseur de la première plaque de circuit est T1 mm, une épaisseur de la seconde plaque de circuit est T2 mm, et une épaisseur du corps fritté en céramique est T3 mm, les formules (2), (3) et (4) suivantes sont établies.

$$-0,004 \times S2 + 0,171 < S1 < -0,032 \times S2 + 1,427 \qquad (1)$$

$$1,7 < (T1 + T2) / T3 < 3,5 \qquad (2)$$

$$T1 \geq T2 \qquad (3)$$

$$T3 \geq 0,25 \qquad (4)$$

**2.** Substrat pour un dispositif à semi-conducteur selon la revendication 1, dans lequel
dans le corps fritté en céramique, une formule (5) suivante est établie.

$$7,5 \leq S2 \leq 25 \qquad (5)$$

**3.** Substrat pour un dispositif à semi-conducteur selon la revendication 1, dans lequel
dans le corps fritté en céramique, une formule (6) suivante est établie.

$$17,5 \leq S2 \leq 23,5 \qquad (6)$$

**4.** Substrat pour un dispositif à semi-conducteur selon l'une quelconque des revendications 1 à 3, dans lequel
dans le corps fritté en céramique, une formule (7) suivante est établie.

$$0,08 < S1 < 1,18 \qquad (7)$$

FIG. 1

EP 3 855 484 B1

FIG. 2

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4717960 B

- JP 2015534280 A